# EUROPÄISCHE PATENTSCHRIFT

(11) **EP 0 341 453 B1**
(45) Veröffentlichungstag und Bekanntmachung des Hinweises auf die Patenterteilung: **25.08.1993**
(21) Anmeldenummer: 89106886.8
(22) Anmeldetag: 18.04.1989
(51) Int. Cl.: H01L 29/06, H01L 29/78

(54) **MOS-Halbleiterbauelement für hohe Sperrspannung**
MOS semiconductor element with a high blocking voltage
Elément semi-conducteur MOS à haute tension de blocage

(30) Priorität: 11.05.1988 DE 3816257
(43) Veröffentlichungstag der Anmeldung: 15.11.1989
(73) Patentinhaber: SIEMENS AKTIENGESELLSCHAFT, 80333 München (DE)
(72) Erfinder: Bergmann, Rainer, Dipl.- Ing., D-8069 Rohrbach (DE); Gantioler, Josef, Dipl.- Ing., D-8000 München 81 (DE)

(56) Entgegenhaltungen:
- EP-A- 0 069 429
- EP-A- 0 077 481
- DE-A- 3 046 749
- US-A- 3 767 981
- IEEE TRANSACTIONS ON ELECTRON DEVICES, Band ED-33, Nr. 12, Dezember 1986, Seiten 1964-1970, IEEE, New York, US; H.R. CLAESSEN et al.: "An accurate DC model for high-voltage lateral DMOS transistors suited for CACD"

## Beschreibung

Die Erfindung bezieht sich auf ein Halbleiterbauelement mit einem Halbleiterkörper mit einem an eine erste Oberfläche angrenzenden Gebiet schwacher Dotierung vom ersten Leitfähigkeitstyp mit den Merkmalen:
a) In der erste Oberfläche des Halbleiterkörpers ist mindestens eine Planarzone höherer Dotierung vom zweiten Leitfähigkeitstyp eingebettet,
b) mit einer ersten Isolierschicht auf der Oberfläche des Halbleiterkörpers,
c) auf der ersten Isolierschicht sitzt am Rand des Halbleiterkörpers eine Channelstopper-Elektrode,
d) auf der ersten Isolierschicht sitzt eine Elektrode, die den die Planarzone begrenzenden pn-Übergang überdeckt,
e) die Elektrode und die Channelstopper-Elektrode sind von einer zweiten Isolierschicht bedeckt,
f) auf der zweiten Isolierschicht liegt eine Channelstopper-Feldplatte, die die Channelstopper-Elektrode mindestens auf der dem Rand des Halbleiterkörpers abgewandten Seite überdeckt und die mit der Channelstopper-Elektrode elektrisch verbunden ist,
g) auf der zweiten Isolierschicht liegt eine Kathoden-Feldplatte, die die Elektrode mindestens auf der von der Planarzone abgewandten Seite überdeckt und die elektrisch mit der Planarzone verbunden ist,
h) zwischen beiden Feldplatten besteht ein Abstand,
i) mit einer höher dotierten Anodenzone an der zweiten Oberfläche des Halbleiterkörpers.

Ein solches Halbleiterbauelement ist in EP-A-0 077 481 bereits beschrieben worden. Es ist in FIG 1 schematisch dargestellt. Das Halbleiterbauelement hat einen Halbleiterkörper 1, in dessen eine Oberfläche 8 eine Zone 2 vom dem Halbleiterkörper 1 entgegengesetzten Leitfähigkeitstyp planar eingebettet ist. Der Halbleiterkörper 1 ist durch einen Rand 4 begrenzt. Auf der Oberfläche 8 ist eine erste Isolierschicht 5 angeordnet, die einerseits bis an den Rand 4 reicht und die andererseits den pn-Übergang 3 dort überdeckt, wo er an die Oberfläche 8 stößt und dem Rand 4 gegenüberliegt. Auf der ersten Isolierschicht 5 sitzt am Rand 4 des Halbleiterkörpers eine Channelstopper-Feldelektrode 7. Auf der anderen Seite ist die Isolierschicht 5 dort, wo sie den pn-Übergang 3 überdeckt, mit einer Elektrode 6 versehen. Diese Elektrode 6 kann beispielsweise im Falle eines MOS-Transistors die Gateelektrode sein und mit einem Gateanschluß G verbunden sein. Auf der ersten Isolierschicht 5 sitzt eine zweite Isolierschicht 9, die die Channelstopper-Elektrode 7 und die Elektrode 6 überlappt und die erste Isolierschicht 5 überdeckt. Auf der zweiten Isolierschicht 9 ist dem Rand benachbart eine Channelstopper-Feldplatte 11 vorgesehen, die mit der Channelstopper-Elektrode 7 elektrisch verbunden ist. Auf der vom Rand 4 abgewandten Seite sitzt auf der zweiten Isolierschicht 9 eine Anoden-Feldplatte 10, die die Elektrode 6 überlappt. Die Feldplatten 10 und 11 haben voneinander einen Abstand. Zwischen den Feldplatten ist die Oberfläche der zweiten Isolierschicht 9 mit einer Passivierungsschicht 12 bedeckt. Diese Passivierungsschicht besteht aus einem schwachleitenden Material z B. aus amorphem Silizium. Dieses amorphe Silizium hat einen definierten spezifischen Widerstand, so daß sich zwischen der Feldplatte 10 und der Feldplatte 11 ein definierter Potentialverlauf einstellen läßt. Damit können die Feldlinien gleichmäßig verteilt aus der Öffnung zwischen den Feldplatten 11 und 12 heraustreten. Mit dieser Maßnahme ist bei insgesamt geringer Dicke der beiden Isolierschichten 5 und 9 eine relativ hohe Sperrspannung des Halbleiterbauelements zu erzielen. An der anderen Seite des Halbleiterkörpers 1 ist eine hochdotierte Anodenzone 15 vorgesehen.

Der spezifische Widerstand und die Stabilität des amorphen Siliziums ist jedoch nicht einfach zu reproduzieren und erfordert beim Herstellen hohe Sorgfalt. Ziel der Erfindung ist es, ein Halbleiterbauelement der eingangs erwähnten Gattung so weiterzubilden, daß sie auch bei der Verwendung anderer, insbesondere isolierender Passivierungsschichten für hohe Sperrspannungen geeignet sind. Hierbei soll der Randbereich, d. h. der Abstand vom Rand 4 bis zu den nächsten, dem Rand benachbarten Planarzonen 2 so klein wie möglich bleiben.

Dieses Ziel wird durch die folgenden Merkmale erreicht:
k) Zwischen der Elektrode und der Channelstopper-Elektrode hat die zweite Isolierschicht einen Bereich, der dicker ist als über den genannten Elektroden,
l) der dickere Bereich liegt dem an die erste Oberfläche angrenzenden Gebiet schwacher Dotierung gegenüber,
m) das dem Rand des Halbleiterkörpers zugewandte Ende der Kathoden-Feldplatte und das dem Rand des Halbleiterkörpers abgewandte Ende der Channelstopper-Feldplatte liegt auf dem Bereich größerer Dicke.

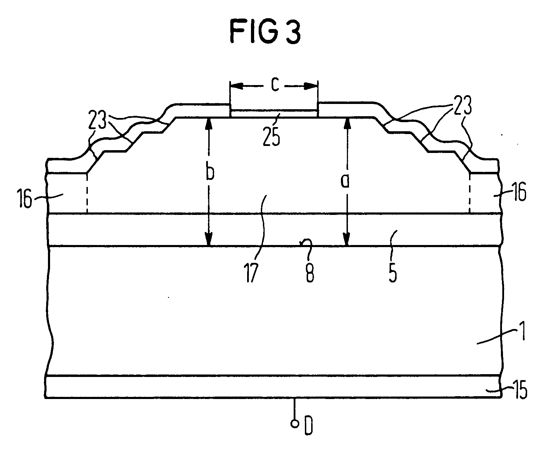

Weiterbildungen der Erfindung sind Gegenstand der Unteransprüche. Die Erfindung wird anhand zweier Ausführungsbeispiele in Verbindung mit den FIG 2 und 3 näher erläutert. Es zeigen
FIG 2 einen teilweisen Schnitt durch ein Halbleiterbauelement gemäß der Erfindung und
FIG 3 einen teilweisen Schnitt durch eine gegenüber FIG 2 abgewandelte Ausführungsform.

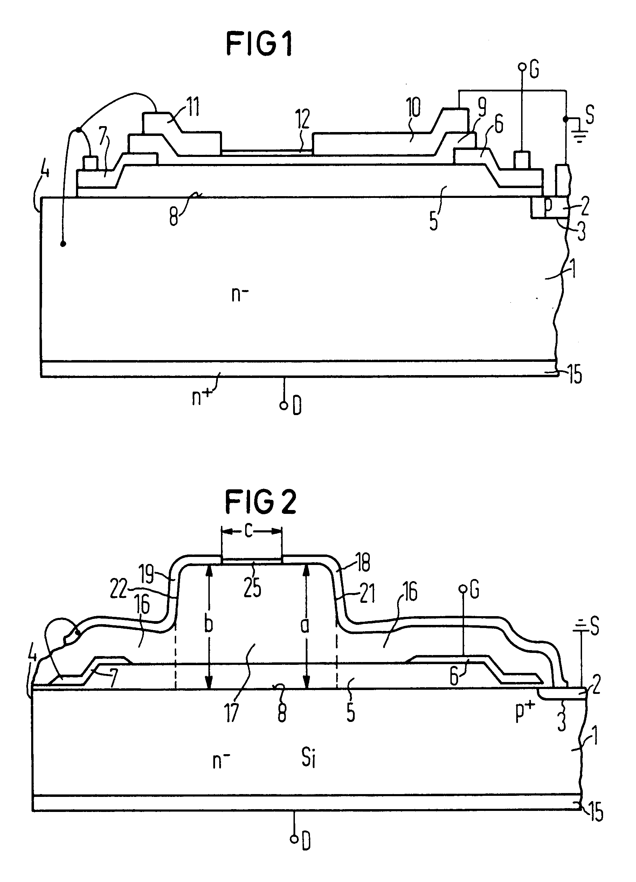

Das Halbleiterbauelement nach FIG 2 ist mit den gleichen Bezugszeichen des Halbleiterbauelements nach FIG 1 bezeichnet, soweit es sich um gleiche oder funktionsgleiche Teile handelt. Es hat eine auf der ersten Isolierschicht 5 liegende zweite Isolierschicht 16, die zwischen der Elektrode 6 und der Channelstopper-Elektrode 7 einen Bereich 17 hat, der größere Dicke aufweist als über den genannten Elektroden 6 und 7. Im Bereich 17, der durch die senkrecht gestrichelten Linien begrenzt ist, kann die gesamte Dicke der Isolierschichten 5 und 16 einige µm betragen. Für eine Sperrspannung von z. B. 1250 Volt ist eine Gesamtdicke der Isolierschicht von 8µm vorgesehen. Der Bereich 17 größerer Dicke ist mit einer Anoden-Feldplatte 18 versehen, die die Elektrode 6 überdeckt und die mit der Planarzone 2 elektrisch verbunden ist. Dabei ist wesentlich, daß die Feldplatte 18 die Elektrode 6 wenigstens auf ihrer dem Rand 4 gewandten Seite überlappt. Die Channelstopper-Elektrode 7 ist von einer Channelstopper-Feldplatte 19 überdeckt, die sich ebenfalls bis in den Bereich 17 größerer Dicke erstreckt. Auch hier ist wesentlich, daß die Feldplatte 19 die Channelstopper-Elektrode 7 wenigstens auf ihrer der Planarzone 2 zugewandten Seite überlappt. Im Bereich 17 haben die Feldplatten 18 und 19 einen definierten Abstand c voneinander. Hier ist die zweite Isolierschicht 16, d.h. ihr Bereich 17 mit einer Passivierungsschicht 25 bedeckt. Die Passivierungsschicht kann eine isolierende Schicht sein, beispielsweise Siliziumnitrid Si₃N₄. Der Abstand c wird definiert derart eingestellt, daß die elektrische Feldstärke zwischen den Feldplatten so hoch ist, daß sich an der Passivierungsschicht 25 anlagernde Ladungen keinen merkbaren Einfluß mehr auf die Feldverteilung zwischen den Feldplatten haben können. Beim obenerwähnten Ausführungsbeispiel hat es als günstig erwiesen, wenn der Abstand c etwa 35µm beträgt.

Die Flanken 21 und 22 des Bereiches 17 können kontinuierlich schräg ansteigend ausgebildet werden oder wie in FIG 3 dargestellt in Stufen 23. Die schrägen Flanken lassen sich durch eine entsprechende Strukturierung des als Isolierschicht verwendeten Oxids erzielen. Hierzu kann z. B. eine Oxidschicht abgeschieden werden, deren Dicke über das gesamte Halbleiterbauelement der Dicke des Bereichs 17 entspricht. Dann werden in die Oberfläche der Oxidschicht beispielsweise Phosphorionen implantiert, die einen oberflächennahen Bereich der Oxidschicht zerstören. Dann wird der Bereich 17 maskiert und der nicht maskierte Bereich geätzt. Durch die oberflächliche Störung der Oxidschicht wird die Maske lateral unterätzt, wobei gleichzeitig die Ätzung vertikal fortschreitet. Dadurch läßt sich eine schräge Flanke erzielen. Das gleiche Verfahren läßt sich beim Ausführungsbeispiel nach FIG 3 sinngemäß anwenden.

Da es im allgemeinen schwierig ist, den Bereich 17 größerer Dicke z.B. durch Abscheiden eines Oxids in einem einzigen Arbeitsgang z.B. 8µm dick herzustellen, empfiehlt es sich, die zweite Isolierschicht durch aufeinanderfolgendes Abscheiden von mehreren dünneren Schichten herzustellen.

Ein besonderer Vorteil der Anordnung besteht darin, daß der zwischen dem Rand 4 und der Planarzone 2 liegende Randbereich sehr schmal gehalten werden kann. Bei einem Halbleiterbauelement für 1200 Volt Sperrspannung hat sich eine Breite von 250µm als ausreichend erwiesen.

Die Herstellung des Halbleiterbauelements ist besonders günstig, wenn die Feldplatten 18, 19 auf dem Bereich 17 den gleichen Abstand voneinander haben (a=b).

## Patentansprüche

1. Halbleiterbauelement mit einem Halbleiterkörper mit einem an eine erste Oberfläche (8) angrenzenden Gebiet (1) schwacher Dotierung vom ersten Leitfähigkeittyp mit den Merkmalen:
a) In der ersten Oberfläche (8) des Halbleiterkörpers ist mindestens eine Planarzone (2) höherer Dotierung vom zweiten Leitfähigkeitstyp eingebettet, die einen pn-Übergang (3) mit dem Gebiet (1) schwacher Dotierung bildet,
b) eine erste Isolierschicht (5) auf der ersten Oberfläche (8) des Halbleiterkörpers,
c) auf der ersten Isolierschicht (5) sitzt am Rand (4) des Halbleiterkörpers eine Channelstopper-Elektrode (7),
d) auf der ersten Isolierschicht sitzt eine Elektrode (6), die den die Planarzone (2) begrenzenden pn-Übergang (3) überdeckt, wo er die erste Oberfläche (8) trifft,
e) die Elektrode (6) und die Channelstopper-Elektrode (7) sind von einer zweiten Isolierschicht (16) bedeckt,
f) auf der zweiten Isolierschicht (16) liegt eine Channelstopper-Feldplatte (19), die die Channelstopper-Elektrode (7) mindestens auf der dem Rand (4) des Halbleiterkörpers abgewandten Seite überdeckt und die mit der Channelstopper-Elektrode elektrisch verbunden ist,
g) auf der zweiten Isolierschicht (16) liegt eine Katoden-Feldplatte (18), die die Elektrode (6) mindestens auf der von der Planarzone (2) abgewandten Seite überdeckt und die elektrisch mit der Planarzone (2) verbunden ist,
h) zwischen beiden Feldplatten (18, 19) besteht ein Abstand (c),
i) eine höher dotierte Anodenzone (15) an einer zweiten Oberfläche des Halbleiterkörpers, **gekennzeichnet durch** die Merkmale:
k) zwischen der Elektrode (6) und der Channelstopper-Elektrode (7) hat die zweite Isolierschicht (16) einen Bereich (17), der dicker ist als über den genannten Elektroden,
l) der dickere Bereich (17) liegt dem an die erste Oberfläche (8) angrenzenden Gebiet (1) schwacher Dotierung gegenüber,
m) das dem Rand des Halbleiterkörpers zugewandte Ende der Kathoden-Feldplatte und das dem Rand des Halbleiterkörpers abgewandte Ende der Channelstopper-Feldplatte liegt auf dem Bereich (17) größerer Dicke.

2. Halbleiterbauelement nach Anspruch 1,
**dadurch gekennzeichnet,** daß der Bereich (17) größerer Dicke schräg ansteigende Flanken (21, 22) hat.

3. Halbleiterbauelement nach Anspruch 1,
**dadurch gekennzeichnet,** daß der Bereich größerer Dicke stufenweise ansteigende Flanken (23) hat.

4. Halbleiterbauelement nach einem der Ansprüche 1 bis 3,
**dadurch gekennzeichnet,** daß die einander zugewandten Enden der Feldplatten den gleichen Abstand (a, b) zur Oberfläche (8) des Halbleiterkörpers haben.

5. Halbleiterbauelement nach Anspruch 1,
**dadurch gekennzeichnet,** daß der Bereich (17) größerer Dicke zwischen den Feldplatten (6, 7) mit einer Passivierungsschicht (25) bedeckt ist.

6. Halbleiterbauelement nach Anspruch 5,
**dadurch gekennzeichnet,** daß die Passivierungsschicht (25) eine isolierende Passivierungsschicht ist.

## Claims

1. Semiconductor component comprising a semiconductor body having a lightly doped region (1) which is adjacent to a first surface (8) and is of the first conductivity type, which component has the features:
a) at least one more heavily doped planar zone (2) which is of the second conductivity type and which forms a p-n junction (3) with the lightly doped region (1) is embedded in the first surface (8) of the semiconductor body,
b) a first insulating layer (5) on the first surface (8) of the semiconductor body,
c) a channel-stopper electrode (7) situated on the first insulating layer (5) at the edge (4) of the semiconductor body,
d) an electrode (6) which spans the p-n junction (3) forming the boundary of the planar zone (2) at the point where it encounters the first surface (8) is situated on the first insulating layer,
e) the electrode (6) and the channel-stopper electrode (7) are covered by a second insulating layer (16),
f) a channel-stopper field plate (19) which spans the channel-stopper electrode (7) at least on the side remote from the edge (4) of the semiconductor body and which is electrically connected to the channel-stopper electrode is situated on the second insulating layer (16),
g) a cathode field plate (18) which spans the electrode (6) at least on the side remote from the planar zone (2) and is electrically connected to the planar zone (2) is situated on the second insulating layer (16),
h) a spacing (c) exists between the two field plates (18, 19),
i) a more highly doped anode zone (15) at a second surface of the semiconductor body, characterized by the features:
k) between the electrode (6) and the channel-stopper electrode (7), the second insulating layer (16) has a region (17) which is thicker than above said electrodes,
l) the thicker region (17) is situated opposite the lightly doped region (1) adjacent to the first surface (8),
m) that end of the cathode field plate which is nearer the edge of the semiconductor body and that end of the channel-stopper field plate which is remote from the edge of the semiconductor body are situated on the region (17) of greater thickness.

2. Semiconductor component according to claim 1, characterized in that the region of greater thickness has edges which rise in bevelled fashion.

3. Semiconductor component according to Claim 1, characterized in that the region of greater thickness has edges (23) which rise in step fashion.

4. Semiconductor component according to one of Claims 1 to 3, characterized in that those ends of the field plates which are nearer one another are at the same spacing (a, b) from the surface (8) of the semiconductor body.

5. Semiconductor component according to Claim 1, characterized in that the region (17) of greater thickness is covered with a passivation layer (25) between the field plates (6, 7).

6. Semiconductor component according to Claim 5, characterized in that the passivating layer (25) is an insulating passivating layer

## Revendications

1. Composant à semiconducteurs comportant un corps semiconducteur possédant une région (1), qui jouxte une première surface (8) et possède un faible dopage correspondant au premier type de conductivité, présentant les caractéristiques suivantes :
a) au moins une zone planar (2), qui possède un dopage supérieur correspondant au second type de conductivité et qui forme une jonction pn (3) avec la région (1) possédant un dopage faible, est insérée dans la première surface (8) du corps semiconducteur,
b) une première couche isolante (5) est disposée sur la première surface (8) du corps semiconducteur,
c) une électrode (7) de dispositif d'arrêt de canal est située sur la première couche isolante (5), au niveau du bord (4) du corps semiconducteur,
d) sur la première couche isolante est disposée une électrode (6), qui recouvre la jonction pn (3) limitant la zone planar (2), à l'endroit où la jonction atteint la première surface (8),
e) l'électrode (6) et l'électrode (7) de dispositif d'arrêt de canal sont recouvertes par une seconde couche isolante (16),
f) sur la seconde couche isolante (16) est disposée une electrode (19) de dispositif d'arrêt de canal, qui recouvre l'électrode (7) de dispositif d'arrêt de canal au moins sur le côté tourné à l'opposé du bord (4) du corps semiconducteur, et est raccordée électriquement à l'électrode de dispositif d'arrêt de canal,
g) sur la seconde couche isolante (16) est disposée une electrode de cathode (18), qui recouvre l'électrode (6) au moins sur le côté opposé à la zone planar (2) et qui est raccordée électriquement à cette zone planar (2)
h) une distance (c) existe entre les deux electrodes (18,19),
i) une zone d'anode plus fortement dopée (15) est située sur une seconde surface du corps semiconducteur, caractérisé par les particularités suivantes :
k) entre l'électrode (6) et l'électrode (7) de dispositif d'arrêt de canal, la seconde couche isolante (7) possède une zone (17), qui est plus épaisse qu'au-dessus desdites électrodes,
l) la zone plus épaisse (17) est située à l'opposé de la zone (1) de faible dopage, qui jouxte la première surface (8),
m) l'extrémité, tournée à l'opposé du bord du corps semiconducteur, de la electrode (18) de cathode et l'extrémité, tournée à l'opposé du bord du corps semiconducteur, de la electrode (19) du dispositif d'arrêt du canal, est située sur la zone (17) possédant une épaisseur accrue.

2. Composant à semiconducteurs suivant la revendication 1, caractérisé par le fait que la zone plus épaisse (17) possède des flancs obliques montants (21,22).

3. Composant suivant la revendication 1, caractérisé par le fait que la zone plus épaisse possède des flancs (23) qui montent en gradins.

4. Composant à semiconducteurs suivant l'une des revendications 1 à 3, caractérisé par le fait que les extrémités tournées l'une vers l'autre, des electrodes (18,19) sont situées à la même distance (a,b) de la surface (8) du corps semiconducteur.

5. Composant à semiconducteurs suivant la revendication 1, caractérisé par le fait que la zone plus épaisse (17) est recouverte par une couche de passivation (25) entre les electrodes (6,7).

6. Composant à semiconducteurs suivant la revendication 5, caractérisé par le fait que la couche de passivation (25) est une couche de passivation isolante.
